# EUROPEAN PATENT APPLICATION

(11) **EP 4 117 032 A1**
(43) Date of publication of application: **11.01.2023**
(21) Application number: 21183737.2
(22) Date of filing: 05.07.2021
(51) Int. Cl.: H01L 23/488, H01L 23/49, H01L 21/60, H01L 25/07, H01L 23/373

(54) **POWER MODULE COMPRISING A PATTERNED SINTERED CONNECTION AND METHOD FOR PRODUCING A POWER MODULE**

(71) Applicant: Hitachi Energy Switzerland AG, 5400 Baden (CH)
(72) Inventor: YAGHOUBI, Farhad, 5400 Baden (CH); ZHANG, Biwei, Lenzburg 5600 (CH); BEYER, Harald, 5600 Lenzburg (CH)
(74) Representative: Epping - Hermann - Fischer

(57) **Abstract**

A power module (10) comprising at least two module components (M) and at least one connection layer (5) is provided, wherein the at least one connection layer (5) is formed along a vertical direction between the at least two module components (M) for mechanically connecting the at least two module components (M). The at least one connection layer (5) is a sintered connection layer forming a sintered connection between the at least two module components (M). Moreover, the at least one connection layer (5) is patterned, and in top view, an area (50) of the sintered connection is only partly covered by a sintering material, wherein subregions (50U) of the area (50), which are not covered by the sintering material, are bordered by one or several outer edges (50E) of the area (50). Furthermore, a ratio of surfaces of the not-covered subregions (50U) to the respective area (50) of the sintered connection is between 10 % and 75 %, inclusive.

Moreover, a method for producing such a power module (10) is provided.

## Description

The present disclosure relates to a power module comprising at least one patterned sintered connection and a method for producing a power module.

Sintering is a well-suited method to establish mechanically strong and highly reliable joining connections. With respect to thermo-mechanical stress as it typically occurs in thermal cycling, the reliability of sintered connections, exemplarily of silver sintered connections, can significantly exceed the reliability of soldered connections. Sintered joining connections, which are prepared for example from silver or copper micro-particles or nano-particles, can be used not only for die bonds, but also for clips or other planar contacts which can be fixed for instance on a top side contact surface of a chip, or for bonding a substrate with a base plate.

Embodiments of the disclosure relate to a power module having reduced internal thermo-mechanical stress. Further embodiments of the disclosure relate to a simplified but efficient method for producing a power module having low internal thermo-mechanical stress.

Embodiments of the disclosure address the above shortcomings in the art in whole or in part. Further embodiments of the power module and of the method for producing the power module are subject matter of the further claims.

According to an embodiment of a power module, it comprises at least two module components and at least one connection layer, wherein the at least one connection layer is formed along a vertical direction between the at least two module components for mechanically connecting the at least two module components. The at least one connection layer is a sintered connection layer forming a sintered connection between the at least two module components. The at least one connection layer is patterned, and in top view, an area of the sintered connection is only partly covered by a sintering material, wherein subregions of the area, which are not covered by the sintering material, are bordered by one or several outer edges of the area. Furthermore, a ratio of surfaces of the not-covered subregions to the respective area of the sintered connection is between 10 % and 75 %, inclusive. For example, the power module is a power semiconductor module. Moreover, the at least one connection layer can also be used for electrically connecting the at least two module components.

In the case of a power module, whose module components are mechanically joined together by a non-patterned or non-structured sintering layer, unwanted deformations may occur during the manufacture or during the operation of the power module due to internal thermo-mechanical stress for instance caused by effects of temperature variations. Such unwanted deformations may result in forming internal cracks within the power module, for example in the joining connections, in delamination of the joining connections, the module components or in other damages of the power module. In contrast, using a patterned sintered connection layer, a very high reliability of the power module with respect to thermo-mechanical stress can be achieved, since the patterned sintered connection layer does not cover the entire area of the sintered connection, is therefore less rigid and in this sense more flexible and may act as a compensating layer for distributing or reducing internal thermo-mechanical stress within the power module, for instance in the joining connections and in corresponding interfaces with the joining partners.

It has been found that using a ratio of surfaces of the not-covered subregions to the respective area of the sintered connection being between 10 % and 75 %, inclusive, a significant reduction of the internal thermo-mechanical stress in the connection layers and in the power module can be achieved. For example, the ratio is between 15 % and 75 %, between 15 % and 65 %, between 15 % and 55 %, between 15 % and 45 %, between 15 % and 35 %, or between 25 % and 75 %, between 35 % and 75 %, between 45 % and 75 %, or between 55 % and 75 %. If the ratio is significantly less than 15 %, for example less than 10 %, 7 %, 5 % or less than 3 %, the effect of reduction of the internal thermo-mechanical stress is very low or hardly present. If the ratio is more than 75 %, a mechanically stable connection between the at least two module components may not always be ensured.

Moreover, an area ratio of surfaces of the not-covered subregions to surfaces of the area of connection covered by the sintering material can be between 0.25 and 4, between 0.5 and 2, between 0.75 and 1.5, between 1 and 1.5, or between 0.75 and 1.25, inclusive.

Moreover, since subregions of the area of the sintered connection, which are not covered by the sintering material, are bordered by one or several outer edges of the area of the sintered connection, these subregions may be used for an improved removal of gases or organics for example during the sintering process resulting in an improved quality of the sintered connections.

In this disclosure, the area of the sintered connection or the area of connection can be considered as overlapping surface or vertical intermediate spaces between the at least two module components, wherein the intermediate spaces are filled by the sintering material in some places and are not filled by the sintering material in other places. The area of the sintered connection can also be defined by a rear side or by a front side of one of the at least two module components. A vertical direction is understood to mean a direction which is directed perpendicular to a main extension surface of one or both of the at least two module components. A lateral direction is understood to mean a direction which is parallel to the main extension surface one or both of the at least two module components. The vertical direction and the lateral direction are orthogonal to each other.

According to a further embodiment, the at least two module components are elements from a group comprising: a base plate, a substrate, an electronic component and an electrical connection. Here, the power module can comprises more than two module components. It is also possible that the power module comprises at least two substrates arranged vertically above each other. Furthermore, it is also possible that power module comprises at least two substrates arranged laterally next to each other and are mechanically and/or electrically connected to each other by a third module component being the electrical connection, which is for instance in form of a clip.

The base plate can be used for example for receiving and carrying the substrate. The base plate can be made of metal or metal alloy, for example, can comprise or made of Cu or Al, or corresponding alloy. Alternatively, it is also possible that the base plate is made of a composite material, for instance from a composite material containing SiC. Such material can be filled with a metallic material like Al or Mg, resulting in AlSiC or MgSiC. The base plate, however, is not restricted to the materials mentioned above.

The substrate can be used for receiving one electronic component or several electronic components. For example, the substrate comprises a front-side metallization and a rear-side metallization, wherein the front-side metallization is vertically separated from the rear-side metallization by an insulating layer. The insulating layer can be made of ceramic material like AlN, Si3N4, Al2O3 or resin material having inorganic filler. The front-side metallization can comprise one first metallization layer and one second metallization layer which is electrically and spatially separated from the first metallization layer for instance by a separating trench. The first metallization layer and the second metallization layer may be assigned to different electrical polarities of the power module or of the electronic component. For example, the electronic component is arranged on the front-side metallization and is electrically connected to both the first metallization layer and the second metallization layer. The front-side metallization can comprise a plurality of first metallization layers and/or a plurality of second metallization layers. The substrate can be a printed circuit board.

The electronic component can be an electronic chip, a semiconductor chip, a sensor for instance for measuring temperature, a switching device like IGBT, a power MOSFET made of silicon, silicon carbide, gallium nitride or other semiconductor material, a diode, a discrete device like resistor, capacitor, inductive component or a transistor, but is not limited thereto.

The electrical connection can be a clip, a terminal, for instance a terminal feet, or a planar contact structure, for instance a platelet, where another connection element is mounted. For example, the electrical connection is used to electrically connect the electronic component with the second metallization of the substrate. For instance, the electronic component is arranged on the first metallization layer, and the electrical connection electrically connects a front-side of the electronic component with the second metallization layer. It is also possible that the electrical connection is configured to interconnect two chip surfaces, for instance two surfaces of two electronic components, or two metallization patterns of the substrate/s. The at least one patterned sintered connection layer can be applied for joining the electrical connection, for instance in form of a terminal feet or other planar contact to a chip surface or to the metallization of the substrate. Furthermore, the at least one patterned sintered connection layer can be applied for joining a contact platelet, which can used for instance for copper wire-bonds, or for joining an terminal on the chip surface, so that an additional sinter connection on the substrate is not required.

According to a further embodiment, the at least one patterned sintered connection layer is located along the vertical direction between the electrical connection and the electronic component, between the electrical connection and the substrate, between the electronic component and the substrate, or between the substrate and the base plate. Depending on the location of the at least one patterned sintered connection layer, it can directly adjoins the base plate, the substrate, the electronic component and/or the electrical connection.

Thus, some joining connections, which may be realized by sintered connection layers, can be located between:
- a chip top surface and the electrical connection for instance in form of a clip, terminal other kind of planar contact element, e.g. a contact platelet;
- the substrate metallization and the electrical connection for instance in form of a clip, terminal other kind of planar contact element;
- the substrate metallization and a chip backside surface (die bond); and/or
- the base plate and the substrate (substrate bond).

Some specific types of joining connections on a top side of a chip may include: a clip interconnecting a chip surface and a substrate surface, a terminal including foot for interconnection, wherein the latter can be related to an external terminal being directly mounted on the chip surface, or other kind of planar contact. The electrical connection can be a contact element in form of a clip, a terminal or another kind of planar contact, e.g. a contact platelet for facilitating wire-bonding with thick copper bond-wires, wherein the contact element can be made of copper, silver, aluminium, or corresponding alloy. The contact element and or the joining surface of the electronic component or substrate may be coated with one additional metal layer, e.g. with a noble metal like gold or silver, to improve the joining process.

The module component can comprise a plurality of connection layers, for example one connection layer between the electrical connection and the electronic component, one connection layer between the electrical connection and the substrate, one connection layer between the electronic component and the substrate, and/or one connection layer between the substrate and the base plate, wherein at least one of the connection layers is sintered. If the power module comprises more than one substrate, the at least one connection layer, for example the at least one sintered connection layer, can also be formed between two substrates.

At least one, two, three or all of these connection layers can be sintered connection layers which are patterned. The sintered connection layers can be patterned in the same manner so that in top view, the patterned sintered connection layers show analogous structure or design. However, different sintered connection layers in different locations can be patterned in different ways so that in top view, different sintered connection layers in different locations may show different structures or designs. It is also possible that one, two or three connection layer/s is/are not patterned sintered connection layer/s and/or not sintered connection layer/s. Instead of the sintered connection layer/s, the one, two or three connection layer/s, which is/are not patterned, can also be ordinary connection layer/s such as soldering layer/s.

According to a further embodiment, the at least one connection layer is contiguous. In other words, all subregions of the at least one connection layer are connected to each other. In top view, the at least one patterned sintered connection layer can have a comb-like, cross-like, star-like or zigzag-like shape, but is not restricted thereto. Locally, the at least one connection layer can show a stripe-like pattern, wherein different subregions of the connection layer can have the form of many stripes, for instance parallel stripes, being connected to each other. The subregions of the area of the sintered connection, which are not covered by the sintering material, can form local intermediate spaces or gaps between different subregions of the connection layer. Such intermediate spaces or gaps can be seen as grooves or trenches which can reach at least one edge or several edges of the sintered connection. In other words, such intermediate spaces or gaps can be bordered by one or several outer edges of the area of the sintered connection.

It is, however, also possible that the at least one connection layer is discontiguous. In this case, the at least one connection layer can comprise spatially separated subregions. In top view, the spatially separated subregions can form a striped or dotted layout. Some or all of the spatially separated subregions can have striped shapes of the same size or of different sizes or dotted shapes of the same size or of different sizes. The dotted shapes can be of any geometric forms. For example, the dotted shape or dotted pattern can comprise multiple dots of round, square, rectangular and/or hexagonal shape. Since connection layer comprises spatially separated subregions, intermediate spaces or gaps between the separated subregions of the connection layer. Similar to the case of a contiguous connection layer, the intermediate spaces or gaps can reach at least one edge or several edges of the sintered connection, i.e. one outer edge or several outer edges of the area of the sintered connection.

In both cases, name in the case of discontiguous connection layer and in the case of contiguous connection layer, the not-covered subregions of the connection area can form channel-like grooves which can laterally stretch from an interior subregion of the connection area towards one or several outer edges of the connection area. Some of the not-covered subregions can be located next to the edge/s of the connection area. The not-covered subregions can be empty spaces, for instance, at least some or all of the not-covered subregions are filled with a gaseous medium like surrounding air, and can be used for removing of gases or organics during the sintering process. This can result in an improved quality of the sintered connections. In some cases, however, it is also possible that the not-covered subregions are filled with an electrically isolating material, for example with a mechanically flexible or soft rigid isolating material for compensating the internal thermo-mechanical stress within the power module, for example within the connection layers. It is also possible that the not-covered subregions are filled with an electrically conductive material being different from a sintering material.

A lateral width, for instance an average lateral width, of the gaps, spaces or channel-like grooves can be greater than 0.1 mm, 0.2 mm, 0.5 mm, 0.7 mm, or greater than 1 mm, for instance between 0.1 mm and 3 mm, 0.5 mm and 3 mm, 1 mm and 3 mm, or between 0.1 mm and 2 mm, 0.5 mm and 2 mm or between 1 mm and 2 mm, but is not limited thereto.

A thickness of the at least one patterned sintered connection layer may be up to 100 µm, for instance between 10 µm and 100 µm, between 10 µm and 80 µm, between 10 µm and 70 µm, or between 20 µm and 50 µm, inclusive. If the layout of the patterned sintered connection layer comprises stripes or dots, the width of the stripes or the diameter or side length of the dots can be in a range of 0.1 mm and 2.0 mm, for instance a range of 0.1 mm and 1.5 mm, 0.1 mm and 1.0 mm, 0.1 mm and 0.5 mm or instance a range of 0.3 mm and 2.0 mm, 0.5 mm and 2.0 mm, 1 mm and 2.0 mm or 1.5 mm and 2.0 mm.

For a substrate bond connection, for instance between the substrate and a base plate, the gaps, spaces or channel-like grooves and/or the pattern or stripes or dots may have a width or length or diameter larger than 2 mm, 3 mm, 5 mm or even larger than 10 mm. The thickness of the connection layer in this case may be larger than 100 µm, 150 µm or 200 µm.

According to an embodiment of a method for producing a power module, for instance a power module described in this disclosure, the method comprises the step of forming the at least one sintered connection layer, wherein a sinter material is applied on a surface or on surfaces of one or of both two module components for instance by stencil printing, by evaporation or sputtering using masks for patterning the at least one connection layer, or by another methods for applying the sinter material. This can also be achieved by structuring an originally homogeneous layer.

As material for the sinter material, silver or copper can be used. For example, nano-size and/or micron-size silver or copper particle can be used. During the sintering process, pressure can be applied, for instance predetermined pressure can be applied, for example, for adjusting the porosity or compactness of the at least one connection layer. Such procedure can be referred to as pressure-applied sintering or pressure-less sintering method. In other words, the sinter process can be done accompanied by high pressure, low pressure, or no pressure. The application of pressure is related to the desired porosity or compactness of the final sintered layer. A higher pressure in the process usually results in lower porosity and consequently in a higher mechanical strength of the sintered layer.

The present disclosure comprises several aspects of a power module and of a method for producing the power module on the basis of their embodiments and examples. Every feature described with respect to one of the aspects is also disclosed herein with respect to the other aspect, even if the respective feature is not explicitly mentioned in the context of the specific aspect. For example, the method described in this disclosure is directed to the production of any of the embodiments of the power module described here. Thus, features and advantages described in connection with the power module can be used for the method, and vice versa.

While the disclosure is amenable to various modifications and alternative forms, specifics thereof are shown by way of example in the figures and will be described in detail. It should be understood, however, that the intention is not to limit the disclosure to the particular described embodiments and examples. On the contrary, the intention is to cover all modifications, equivalents, and alternatives falling within the scope of the disclosure defined by the appended claims.

The accompanying figures are included to provide a further understanding. In the figures, elements of the same structure and/or functionality may be assigned to the same reference signs. It is to be understood that the examples shown in the figures are illustrative representations and are not necessarily true to scale.
Figure 1 shows a general concept of a power module according to an example.
Figure 2A shows a concrete realization of a power module according to an example.
Figures 2B, 2C, 3A, 3B, 3C, 3D, 3E and 3F show different layouts of a connection layer according to different examples.
Figures 4A, 4B, 4C, 4D, 4E, 4F, 4G, 5A, 5B, 5C, 6A, 6B and 6C show a power module according to another example and several simulations using "von Mises Stress" showing the distribution of thermo-mechanical stress in different connection layers and in different module components of the power module.

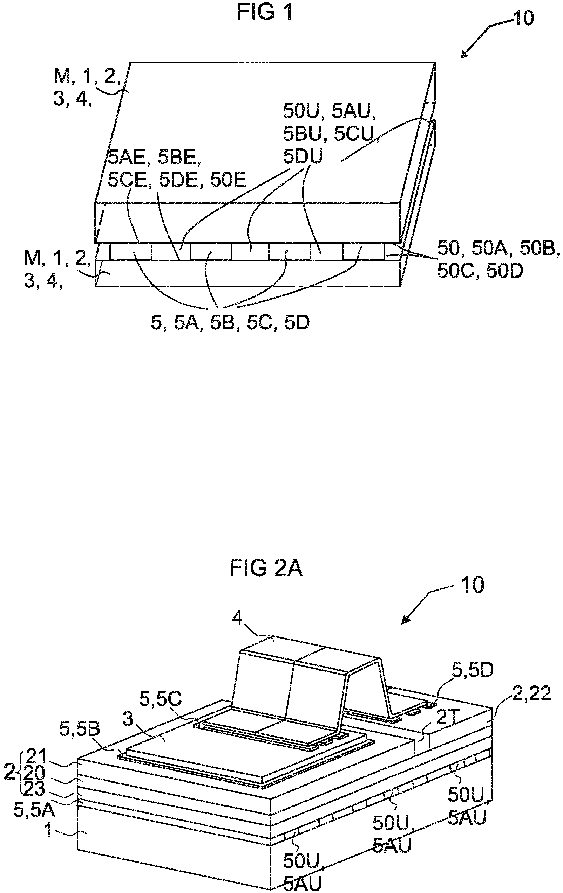

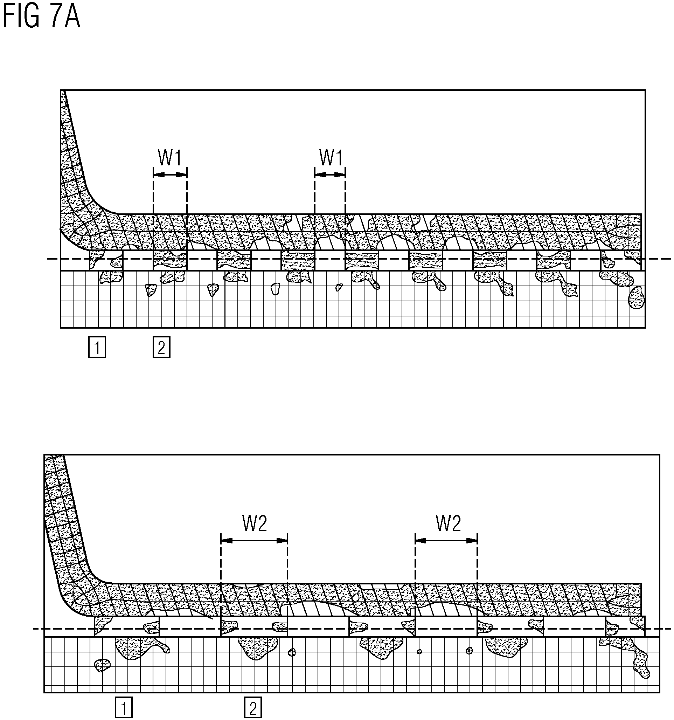

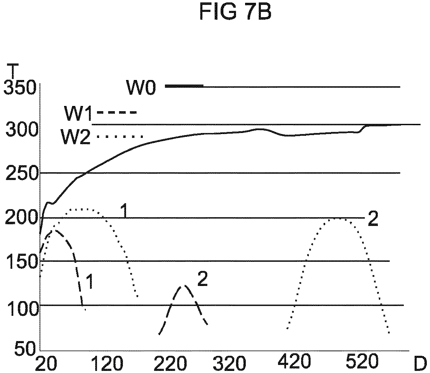

Figures 7A and 7B show 2D-simulations referring to a cross section according to the length direction of the clip, wherein Figure 7A shows cross sections of the power module at a patterned sintered connection layer having a stripe layout comprising stripes of different sizes including stress distribution obtained by "von Mises stress", and Figure 7B shows the distribution of thermo-mechanical stress in a power module comprising a connection layer having two striped layouts of different sizes, wherein the thermo-mechanical stress is obtained along the dashed lines shown in Figure 7A. Figure 1 shows a power module 10 comprising at least two module components M and at least one connection layer 5. The module component M can be a base plate 1, a substrate 2, an electronic component 3 or an electrical connection 4. The at least one connection layer 5 is formed along a vertical direction between two module components M for mechanically connecting the two module components. The at least one connection layer 5 can also be used for thermally, in some cases also for electrically, connecting the two module components. The at least one connection layer 5 can be one connection layer 5 in form of a lower connection layer 5A formed between the base plate 1 and the substrate 2, one connection layer 5 in form of a first connection layer 5B formed between the substrate 2 and the electronic component 3, one connection layer 5 in form of a second connection layer 5C formed between the electronic component 3 and the electrical connection 4, or one connection layer 5 in form of a third connection layer 5D formed between the substrate 2 and the electrical connection 4.

For instance, as shown for instance in Figure 2A, the connection layer 5A mechanically and/or thermally connects the base plate 1 with the substrate 2. The connection layer 5B mechanically and electrically and/or thermally connects the electronic component 3 with the substrate 2. The connection layer 5C mechanically and electrically and/or thermally connects the electronic component 3 with the electrical connection 4 which can be a clip, a terminal or a planar contact element. The connection layer 5D mechanically and electrically and/or thermally connects the electrical connection 4 with the substrate 2, for example if the electrical connection 4 is a clip. If the electrical connection 4, however, is a terminal or a planar contact element, the connection layer 5D can be absent. The terminal or the planar contact element can be mechanically and electrically connected to the electronic component 3 by the connection layer 5C. Moreover, for instance by using a bond-wire, the terminal or the planar contact element can be electrically connected to a metallization layer 22 of the substrate 2.

Exactly or at least one, two, three or all of the connection layers 5, 5A, 5B, 5C, 5D can be formed as a sintered connection layer which forms a sintered connection between two respective module components M, 1, 2, 3 and 4. The sintered connection can be patterned in such a way that in top view, an area 50 of the sintered connection is only partly covered by a sintering material. The area 50 can be an area 50A between the base plate 1 and the substrate 2, an area 50B between the electronic component 3 and the substrate 2, an area 50C between the electronic component 3 and the electrical connection 4, or an area 50D between the electrical connection 4 and the substrate 2.

For example, the area 50A can be defined by joining surfaces of the base plate 1 and the substrate 2. The area 50B can be defined by joining surfaces of the electronic component 3 and the substrate 2. The area 50C can be defined by joining surfaces of the electronic component 3 and the electrical connection 4. The area 50D can be defined by joining surfaces of the electrical connection 4 and the substrate 2.

If any of the connection layers 5, 5A, 5B, 5C and 5D is patterned, the corresponding area of connection 50, 50A, 50B, 50C or 50D can comprise subregions 50U, 5AU, 5BU, 5CU or 5DU which are not covered by the sintering material. As shown in Figures 1 and 2A, any of the connection layers 5A, 5B, 5C and 5D can have a striped layout. In this case, the subregions 5AU, 5BU, 5CU or 5DU are lateral spaces between the stripes or surrounding the stripes. The subregions 50U, 5AU, 5BU, 5CU and 5DU can be bordered by one or several outer edges 50E, 5AE, 5BE, 5CE and 5DE of the connection area 50A, 50B, 50C, 50D, respectively. It is also possible that one or some of the connection layers 5A, 5B, 5C and 5D is/are not sintered and/or patterned connection layers.

Thus, the not-covered subregions 50U may form channel-like grooves which laterally stretch from an interior subregion of the connection area 50 towards one or several outer edges 50E of the connection area 50. The channel-like grooves can be used for removing gases or organics during the sintering process. On the connection area 50, the not-covered subregions 50U may form a continuous structure. In this case, the connection area 50 can be void of a not-covered interior subregion which is completely surrounded by the connection layer 5. Thus, the connection area 50 does not comprise any interior subregion, where gases or organics may be trapped. It is, however, also possible, that the connection area 50 comprises at least one not-covered interior subregion which - in lateral directions - is completely surrounded by the connection layer 5.

Furthermore, the not-covered subregions 50U can act as compensating regions for distributing or reducing internal thermo-mechanical stress within the power module. The not-covered subregions 50U, i.e. 5AU, 5BU, 5CU or 5DU, may be empty and can be filled with surrounding air. In some cases, however, it is also possible that the not-covered subregions 50U are partly filled with an electrically isolating material, for example with an encapsulating material. It is also possible that the not-covered subregions 50U are filled with an electrically isolating material, for example with a mechanically flexible, elastic or soft rigid isolating material for compensating the internal thermo-mechanical stress, or are filled with an electrically conductive material being different from a sintering material. For example, at least one or all of the connection layers 5A, 5B, 5C or 5D is/are a silver or copper sintered connection layer/s. Because of the high mechanical strength, silver or copper sintered joining connections provide a very high reliability with respect to thermo-mechanical stress. Consequently, silver or copper sintered connections have a strong potential to enhance the product lifetime significantly.

Silver or copper sintered connections, however, provide a clearly higher rigidity than soldered connections. This may result in higher thermo-mechanical stress in the sintered connection itself, but also in the joining partners adhering to the joining connection and the corresponding interfaces due to of the mismatch in the thermal expansion coefficients of silver with 18.9 ppm/K, copper with 16.4 ppm/K and of materials of the joining partners like silicon with 2.49 ppm/K and aluminium with 24 ppm/K.

So mutual joining connections between an electronic component 3 for instance in form of an electronic chip, an electrical connection 4 for instance in form of a clip, and the substrate 2 as well as in a connection between the substrate 2 and the base plate 1 may suffer high thermo-mechanical stress because of the different thermal expansion coefficients of silicon and copper. Additionally, comparably soft metallization layers e.g. made of aluminium used as contact metallization of the electronic component 3 shall also be considered, which are not well-suited for high mechanical stress. In the case of soldered connections, this stress can be partly compensated by the comparably soft solder material but accompanied by a limited reliability of the soldered connection itself.

In the case of a more rigid silver or copper sintered connection, a clearly higher reliability of the joining connection itself is achieved. By structuring the sintered connection layers 5A, 5B, 5C and/or 5D, possible weak points in the connection layers 5A, 5B, 5C and/or 5D can be remedied resulting in stress reduction, so that the risks with regard to delamination or other to damages to the contact metallization, the connection layers or the joining partners during long-term operation can be minimized.

Figure 2A is a perspective view of a power module 10 according to an embodiment. The power module 10 comprises four module components which are the base plate 1, the substrate 2, the electronic component 3 and the electrical connection 4. The power module 10 comprises one lower sintered connection layer 5A which directly adjoins the base plate 1 and the substrate 2. Thus, the base plate 1 is mechanically connected to the substrate 2 via the lower sintered connection layer 5A.

The substrate 2 has a first metallization layer 21 and a second metallization layer 22 which is spatially and electrically separated from the first metallization layer 21 by a separating trench 2T. The first and second metallization layers 21 and 22 are assigned to different electrical polarities/voltage potentials of the power module 10. The substrate 2 further comprises a rear-side metallization 23 and an insulating layer 20, wherein the insulating layer 20 is arranged along the vertical direction between the rear-side metallization 23 and the first and second metallization layers 21 and 22. Within the separating trench 2T, the insulating layer 20 may be exposed. The first and second metallization layers 21 and 22 and the rear-side metallization may be made of the same material or of different materials. The substrate metallizations 21, 22 and/or 23 may be made of copper or aluminum, or corresponding alloy. A coating with a metal layer like nickel, gold, silver or other metal is also possible. The insulating layer 20 layer may be ceramic material like Si3N4, AlN, Al2O3 or resin which can comprise inorganic filler.

One first sintered connection layer 5B is arranged between the substrate 2 and the electronic component 3. Thus, the electronic component 3 can be electrically and thermally connected to the first metallization layer 21 by the first sintered connection layer 5B. The electronic component 3 can be a semiconductor chip, but is not limited thereto.

One second sintered connection layer 5C is formed between the electronic component 3 and the electrical connection 4. In Figure 2A, the electrical connection 4 is a clip. One third sintered connection layer 5D is formed between the substrate 2 and the electrical connection 4.

In this disclosure, the terms "first", "second", "third" and "fourth" are intended to distinguish between similar parts but do not necessarily indicate a specific order or sequence. For instance, the lower sintered connection layer 5A can be assigned as the fourth sintered connection layer 5A. It should be understood that these terms are interchangeable in proper circumstances.

According to this disclosure, least one, two, three or all of the connection layers 5A, 5B, 5C and 5D is/are patterned sintered connection layers. In Figure 2A, only the sintered connection layers 5A, 5C and 5D are patterned. In deviation from this, it is also possible that exactly one or exactly three of the sintered connection layers 5A, 5B, 5C and 5D is/are patterned while the remaining connection layer/s is/are not patterned.

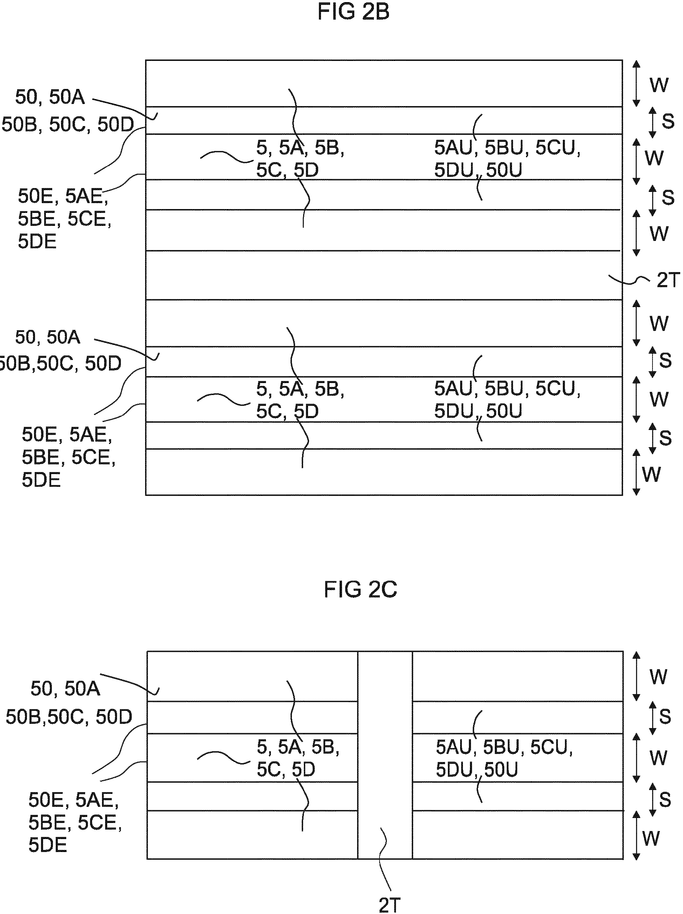

According to Figure 2A, the second sintered connection layer 5C and the third sintered connection layer 5D are patterned and have a striped layout comprising a plurality of stripes. The stripes are oriented in parallel to the separating trench 2T as shown for instance in Figure 2B, i.e. perpendicular to the main extension direction of the clip. Apart from this, as shown in Figure 2C, it is also possible that the second sintered connection layer 5C and the third sintered connection layer 5D comprise a plurality of stripes which are oriented perpendicular to the separating trench 2T, i.e. in parallel to the main extension direction of the clip.

Figures 2B and 2C show top views of the patterned sintered connection layer 5. Any of the patterned sintered connection layer 5A, 5B, 5C and 5D can have the striped layout comprising a plurality of parallel stripes. In case of the connection layers 5C and 5D, the stripes can be in parallel to or oriented perpendicular to the separating trench 2T. In case of the connection layers 5A and 5B, the separating trench 2T is not present.

The stripes are formed by separated subregions of the connection layer 5. These subregions partly cover the area of connection 50. In other word, these subregions correspond to subareas of the area of connection 50A, 50B, 50C or 50D which are covered by a sintering material. In Figures 2B and 2C, the subregions of the connection layer 5A, 5B, 5C or 5D have a lateral width W. The width W can be between 0.1 mm and 2.0 mm or larger.

The area of connection 50 comprises subregions or subareas 50U, which are not covered by the sintering material. The subregions or subareas 50U are bordered by two opposite edges 50E of the corresponding area 50. The not-covered subregions or subareas 50U have a lateral width S. The width S can be greater than 0.1 mm, 0.3 mm or greater than 0.5 mm. For example, the width S is equal to, smaller or larger than the width W. According to Figures 2B and 2C, the not-covered subregions or subareas 50U form channel-like grooves which laterally stretch from one outer edge over an interior subregion to another opposite outer edge of the area of connection 50.

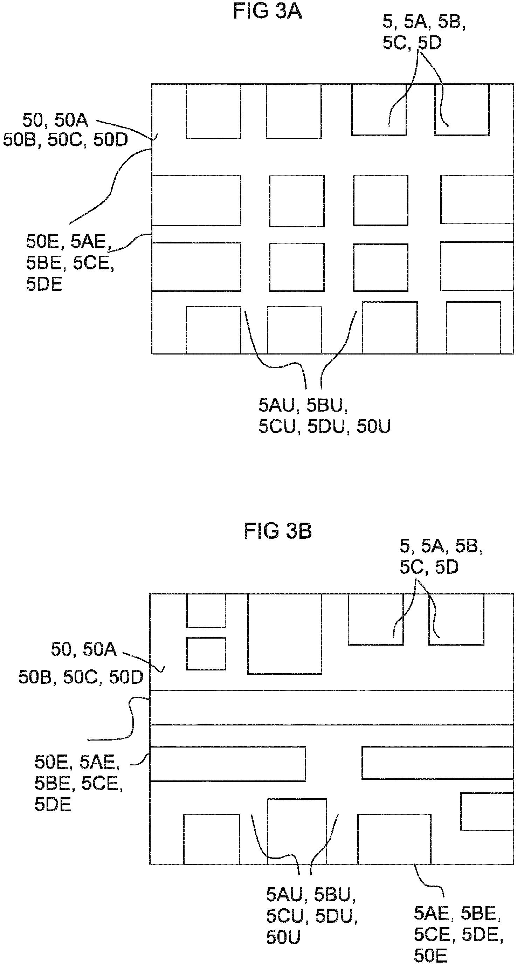

Figure 3A shows a top view of the patterned sintered connection layer 5 which can be one of the connection layers 5A, 5B, 5C and 5D. Any of the patterned sintered connection layer 5A, 5B, 5C and 5D can have a so-called dotted layout comprising a plurality of dots. In Figure 3A, the subregions of the sintered connection layer 5and the not-covered subregions 50U of the area of connection 50 has an irregular structure. The dots can have round, square, rectangular, hexagonal or other geometrical shape. The dots can have equal or different geometrical sizes. A diameter or a side length of the dots can be between 0.1 mm and 2.0 mm or larger. The dots can be distributed evenly or unevenly on the area of connection 50.

A further example of discontiguous connection layer 5 which can be any of the connection layers 5A, 5B, 5C and 5D, is shown in Figure 3B. Such connection layer can comprises a plurality dots and a plurality of stripes.

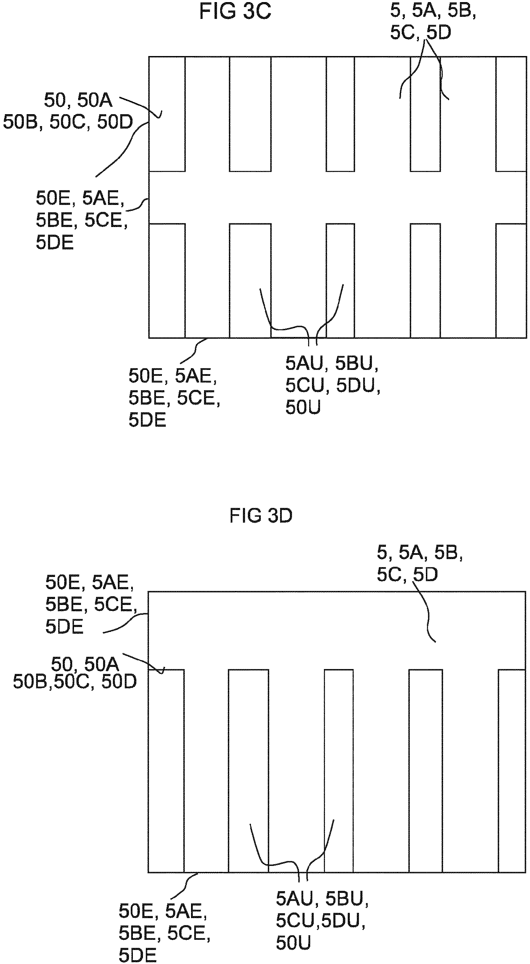

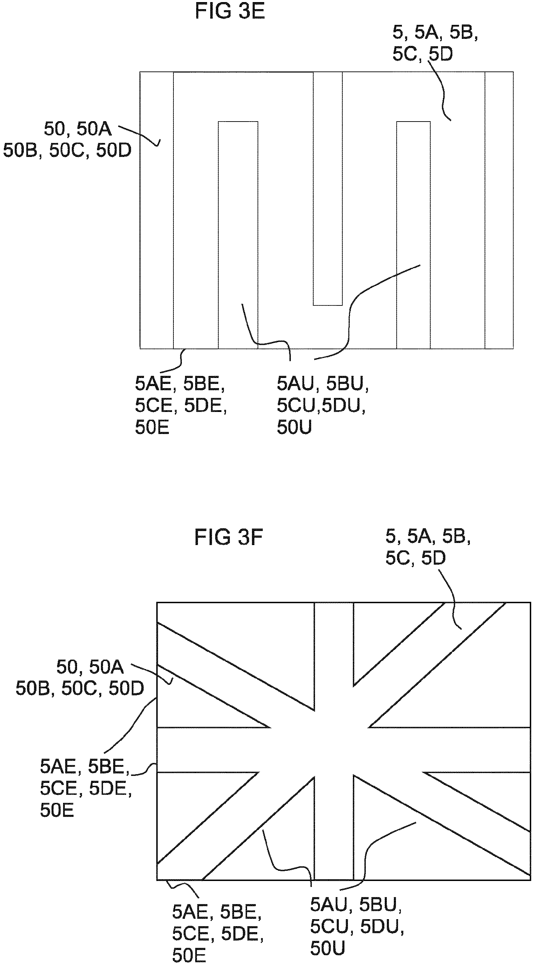

Figures 3C, 3D, 3E and 3F show exemplary layouts of a contiguous connection layer 5A, 5B, 5C or 5D, which - according to Figure 3C - has a cross-like or fence-like shape, - according to Figure 3D - a comb-like shape, - according to Figure 3E - a zigzag-like or meander-like shape and according to Figure 3F has a star-like shape.

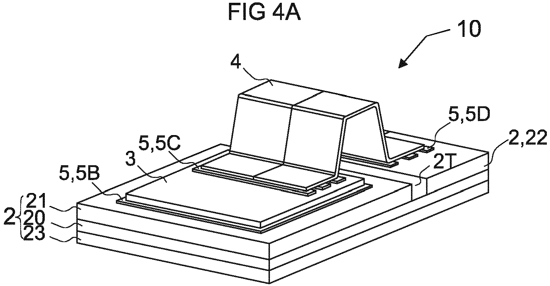

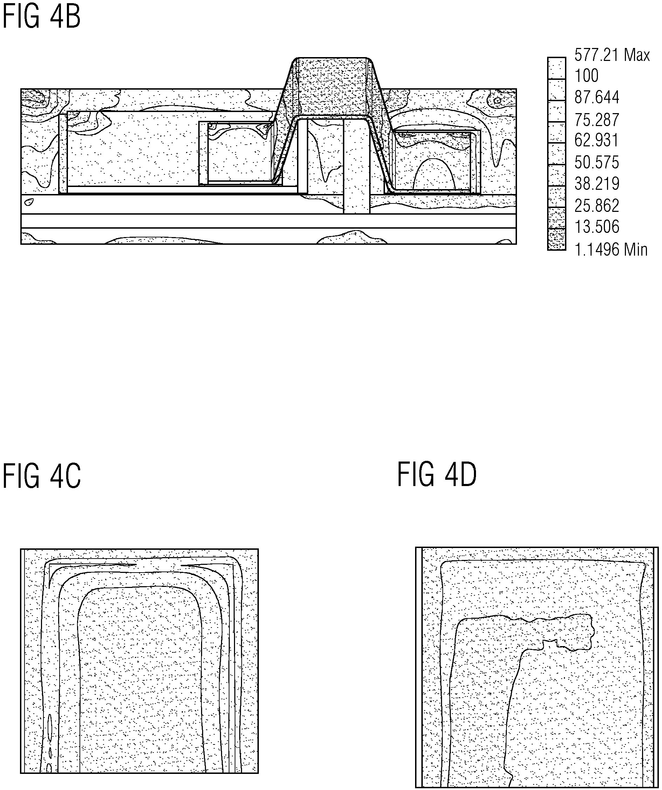

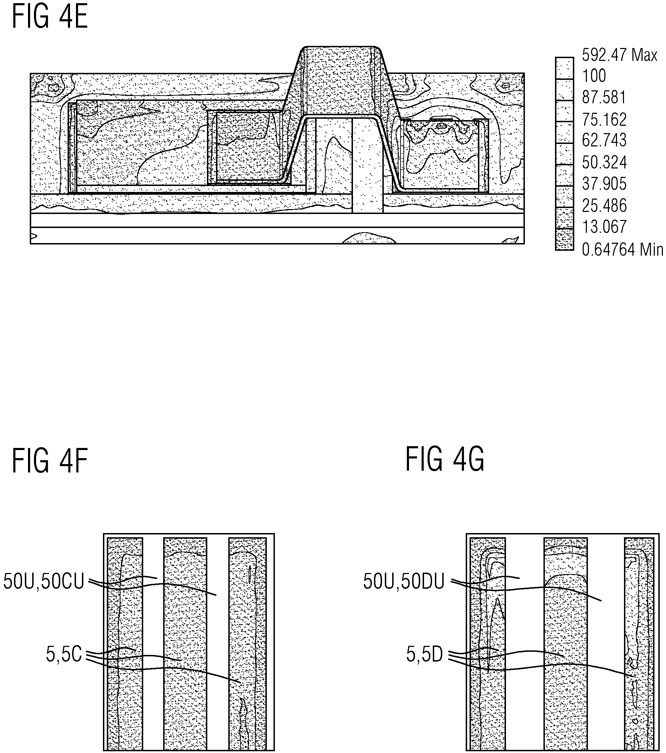

Figure 4A shows the power module 10 of Figure 2A without the base plate 1 and the connection layer 5A. Figures 4B, 4C and 4D describe a simulation obtained by "von Mises stress" showing distributions of thermo-mechanical stress within the module components 2, 3 and 4 of the power module 10 in the presence of the not patterned first connection layers 5B, 5C and 5D as shown in Figure 4A. Figures 4E, 4F, 4G, 5A, 5B, 5C, 6A, 6B and 6C describe several simulations showing distributions of thermo-mechanical stress within the module components 2, 3 and 4 of the power module 10 in the presence of the not patterned first connection layer 5B and the patterned sintered connection layers 5C and 5D as shown in Figure 4A. The simulations were carried out for half of the clip 4.

Figure 4B shows results of a simulation on a setup of the power module 10 comprising the electronic component 3 being a chip, wherein electronic component 3 is joined to the first metallization layer 21 of substrate 2. The second metallization layer 22 of the substrate and the chip surface are electrically interconnected by the electrical connection 4 being a copper clip joined on one hand on a surface of the second metallization layer 22 and on the other hand on a top side contact of the electronic component 3 by silver sintering.

As shown in Figure 4B, in the case that the sintered connection layers 5B, 5C and 5D are not patterned, large stress accumulation occurs not only on the chip and on the clip. Figures 4C and 4D show local stress maxima on the edges of the sintered connection layers 5B and 5C. This large stress accumulation might result in damages or in a delamination of the contact metallization made of soft aluminium, for example, and also damages on the sintered layer.

Figure 4C shows - in top view - a calculated distribution of thermo-mechanical stress on the side of the electronic component 3, namely the stress distribution on the interface between sintered connection layer 5C and the clip 4. Figure 4D shows - in top view - a calculated distribution of thermo-mechanical stress on the side of the substrate 2, here on the interface between the sintered connection layer 5D and the clip 4.

As shown in Figure 4B, large stress is generated not only in the sintered connections, but also in the joining partners. Improvement of the mechanical strength of the setup can be obtained by use of a harder and/or stronger contact metallization of the chip or the need of a stress reduction in the joining connection resulting in an improved reliability with respect to thermal cycles. It has been found that the stress reduction in the sintered joining connections is very effective with regard to the enhancement of reliability of the power module with respect to thermal cycles.

The stress reduction is achieved by a patterned sintered connection. Whereas the joining connections of the copper clip interconnecting chip surface and substrate surface shown in Figure 4B-4D were prepared by homogeneous layers of sintered silver, the present disclosure suggests a patterning of such homogeneous layers. In this case the area of connection is not completely covered by a sintering material such as silver.

As shown in Figure 4A, the connection layers 5C and 5D comprise multiple stripes of sintered silver interrupted by multiple spaces. Such spaces are subregions 5CU and 5DU of the connection areas 50C and 50D, respectively, which are not covered by the sintering material and are bordered by one or several outer edges 5CE or 5DE of the connection areas 50C or 50D (see also Figures 2B or 2C).

Figure 4E shows results of finite element (FEM) simulations on the setup shown in Figure 4A. Except from the patterned structures of the sintered connection layers 5C and 5D, the setup is equal to the setup used for the stress simulations shown in Figure 4B. Here, a striped layout according to Figure 2B is used, wherein the stripes are parallel to the trench 2T or perpendicular to main direction of the clip.

The patterned connection layer 5C or 5D comprises three stripes of sinter material having a width of 500 µm, which are separated by not-covered subregions 5CU or 5DU which form gaps or spaces having a width of 200 µm. The stripes have a length direction perpendicular to a main orientation of the clip, i.e. of the electrical connection 4, or parallel to the separating trench 2T. The results show a strong reduction of the stress in the sintered joining connection for the patterned structure compared with a homogeneous sintered layer, namely about three times less. Here, the stress on both joining partners and also in the sinter layer is strongly reduced. Consequently, a significant improvement of the reliability of the power module 10 with respect to thermal cycling can be expected achieved.

Similar to Figures 4C and 4D, Figure 4F shows - in top view - a calculated distribution of thermo-mechanical stress on the interface between sintered connection layer 5C and the clip 4, and Figure 4G shows - in top view - a calculated distribution of thermo-mechanical stress on the interface between the sintered connection layer 5D and the clip 4.

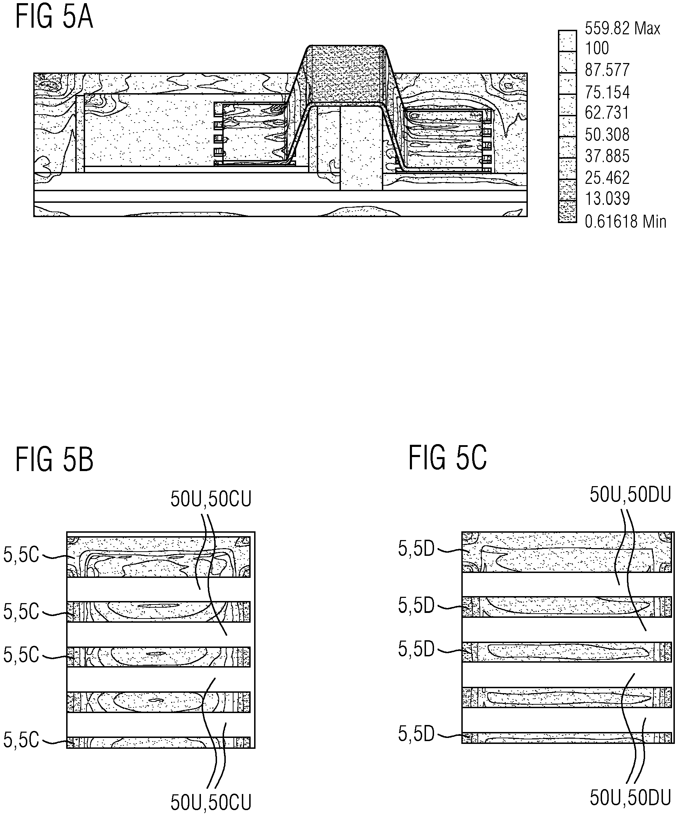

Figures 5A, 5B and 5C essentially correspond Figures 4E, 4F and 4G, respectively. In contrast, according to Figures 5A, 5B and 5C, the sintered connection layers 5C and 5D are prepared by stripes, which are orientated in parallel with respect to the main extension direction of the clip, i.e. of the electrical connection 4, or orthogonal to the main extension direction of the separating trench 2T. Moreover, different stripes have different widths. This layout results in another distribution of thermo-mechanical stress in the sintered connection layers 5C and 5D compared to the use of a homogeneous sintered connection layers. Here, although the local stress maxima at the edges of the clip are stronger compared with the homogeneous case, the stress in the center of the sintered connection is reduced. However, it shall be considered that the occurring stress is concentrated, but also limited to the comparably smaller areas of the stripes.

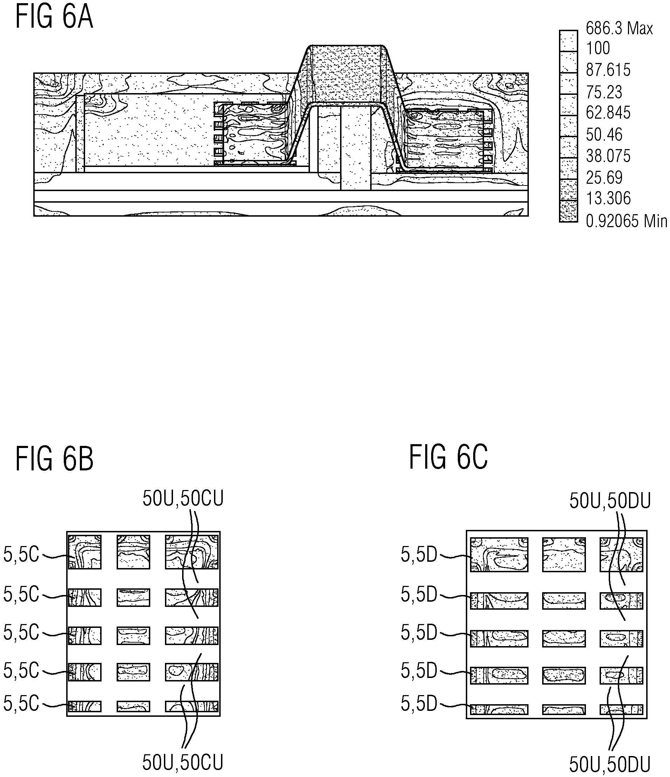

Figures 6A, 6B and 6C essentially correspond to Figures 5A, 5B and 5C, or to Figures 4E to 4G, respectively. In contrast, according to Figures 6A, 6B and 6C, the patterned sintered connection layers 5C and 5D are prepared by dots, i.e. they are dot-like (see also Figure 3A for an example).

In Figures 4E to 5C, the not-covered subregions 5CU or 5DU form channel-like grooves, which are separated from each other and in each case laterally stretch from one outer edge to another opposite outer edge of the area of connection 50C or 50D. In contrast, in Figures 6A, 6B and 6C, the not-covered subregions 5CU or 5DU form channel-like grooves form a connected network, i.e. they are contiguous. The connected network channel-like grooves are bordered all outer edges 5CE and 5DE of the respective area of connection 50C or 50D (see also Figures 3A and 3B).

Compared to Figures 5A, 5B and 5C, according to the setup described in Figures 6A, 6B and 6C, even less sinter material is needed, since the sinter material is present only in regions of the dots or dot-like structures, which are separated from each other by gaps in horizontal and vertical directions. Figure 6A shows the results of finite element simulations on a clip, where the sintered connections are prepared as areas of several dots. This layout also results in an overall stress reduction compared with the use of homogeneous sintered layers. Although the local stress maxima at the edges of the clip are stronger compared with the homogeneous case, the stress in the center of the sintered connection is reduced. However, it shall be considered that the occurring stress is concentrated to the comparably smaller areas of the dots.

It appears that a striped layout with the orientation of the stripes as shown in Figure 4E may be best suited for the joining connections of the clip. Nevertheless, alternative layouts like dotted pattern or striped layouts with other orientations are also well-suited for joining connections of terminals or other types of planar contacts on the surface of chips or substrates. Here, layouts are possible, where a homogeneous sinter layer is only partly interrupted by grooves, as it occurs e.g. in a star-like or cross-like shape, or in other shapes shown for examples in Figures 3A to 3F.

Moreover, additional improvement for the stripped layout can achieved by choosing suitable widths and/or distances of the stripes. Figure 7A shows a 2D simulation of the stress distribution referring to a cross section of the clip 4 sintered to the substrate 2. Fig. 7B shows the stress distribution along a line inside the sintered layer (dashed line in Figure 7A). The patterned sintered connection layer has a striped layout comprising stripes parallel to separating trench 2T or perpendicular to the main orientation of clip 4, wherein on one hand a stripe width W = W1 and gap width S of 100 µm was chosen, and on the other hand a stripe width W = W2 and gap width S of 200 µm was chosen. In Figure 7B, the distribution of thermo-mechanical stress T in a non-patterned homogeneous connection layer, thus with one single "stripe" having the maximal width W = W0, is also shown for comparison purposes.
The stress curves shown in Figure 7B are determined at the center of the sintered connection layer 5D, namely along the dashed lines in Figures 7A, in a two-dimensional simulation.

Exemplarily, Figure 7A shows the distribution of stress on the substrate side. Figure 7B also shows the distribution of stress on the substrate side, i.e. in the connection layer 5D between the clip 4 and the substrate 2, as a function of D indicating the distance from stripe's edge. It has been found that a stronger stress reduction is achieved for the smaller stripe width W = W1 and distance. The results show that the smaller stripe width of 100 µm provides an even larger stress reduction compared with the stripe width and distance of 200 µm. Consequently, the use of stripes having a small width is advantageous with respect to the reduction of thermo-mechanical stress in a patterned sintered connection.

Similar patterned sintered connection layers 5B and 5A may be applied for the joining connections between the substrate 2 and the electronic component 3 or between the substrate 2 and the base plate 1, respectively. Also for these joining connections, an improved reliability of the connection layers 5A and 5B or of the power module 10 with respect to thermo-mechanical stress can be expected.

The embodiments shown in the Figures as stated represent exemplary embodiments of the improved arrangement for a power module; therefore, they do not constitute a complete list of all embodiments according to the improved arrangement for the power module. Actual arrangements of the power module may vary from the exemplary embodiments described above.

### Reference signs

- 10: power module
- M: module component
- 1: module component; base plate
- 2: module component; substrate
- 20: insulating layer
- 21: first metallization layer
- 22: second metallization layer
- 23: rear-side metallization
- 2T: separating trench
- 3: module component; electronic component
- 4: module component; electrical connection

- 5: connection layer
- 5A: lower/fourth connection layer; connection layer between base plate and substrate
- 5B: first connection layer; connection layer between substrate and electronic component
- 5C: second connection layer; connection layer between electronic component and electrical connection
- 5D: third connection layer; connection layer between electrical connection and substrate

- W, W0, W1, W2: width of subregions of the connection layer

- 50: area of connection
- 50A: area of connection between base plate and substrate
- 50B: area of connection between substrate and electronic component
- 50C: area of connection between electronic component and electrical connection
- 50D: area of connection between substrate and electrical connection
- 50U: not-covered subregion of area of connection 50
- 5AU: not-covered subregion of area of connection 50A
- 5BU: not-covered subregion of area of connection 50B
- 5CU: not-covered subregion of area of connection 50C
- 5DU: not-covered subregion of area of connection 50D

- S: width of channel-like grooves formed by subregions of the not-covered subregion

- 50E: outer edge of area of connection 50
- 5AE: outer edge of area of connection 50A
- 5BE: outer edge of area of connection 50B
- 5CE: outer edge of area of connection 50C
- 5DE: outer edge of area of connection 50D

## Claims

1. A power module (10) comprising at least two module components (M) and at least one connection layer (5), wherein
- the at least one connection layer (5) is formed along a vertical direction between the at least two module components (M) for mechanically connecting the at least two module components (M),
- the at least one connection layer (5) is a sintered connection layer forming a sintered connection between the at least two module components (M),
- the at least one connection layer (5) is patterned, and in top view, an area (50) of the sintered connection is only partly covered by a sintering material, wherein subregions (50U) of the area (50), which are not covered by the sintering material, are bordered by one or several outer edges (50E) of the area (50), and
- a ratio of surfaces of the not-covered subregions (50U) to the respective area (50) of the sintered connection is between 10 % and 75 %, inclusive.

2. The power module (10) according to claim 1, wherein the not-covered subregions (50U) of the area (50) form channel-like grooves which laterally stretch from an interior subregion of the area (50) towards one or several outer edges (50E) of the area (50).

3. The power module (10) according to one of the previous claims, wherein at least some or all of the not-covered subregions (50U) of the area (50) are empty spaces filled with air or with an insulating material or with a conductive material different from a sintering material.

4. The power module (10) according to one of the previous claims, wherein the at least one connection layer (5) is contiguous.

5. The power module (10) according to the previous claim, wherein the at least one connection layer (5) has a comb-like, cross-like, star-like, zigzag-like or meander-like shape.

6. The power module (10) according to one of claims 1 to 3, wherein the at least one connection layer (5) is discontiguous.

7. The power module (10) according to the previous claim, wherein the at least one connection layer (5) comprises spatially separated subregions forming a striped or dotted pattern.

8. The power module (10) according to one of the previous claims, wherein the at least two module components (M) are elements from a group comprising: a base plate (1), a substrate (2), an electronic component (3) and an electrical connection (4).

9. The power module (10) according to one of the previous claims comprising at least three module components (M) being a substrate (2), an electronic component (3) and an electrical connection (4), wherein
- the substrate (2) has a first metallization layer (21) and a second metallization layer (22) spatially separated from the first metallization layer (21) by a separating trench (2T),
- the electronic component (3) is a semiconductor chip which is electrically and thermally connected to the first metallization layer (21) by one connection layer (5) in form of a first connection layer (5B),
- the electrical connection (4) is a metal clip or a planar contact or terminal which is electrically connected to the electronic component (3) by one connection layer (5) in form of a second connection layer (5C), and
- at least one or both of the connection layers (5B, 5C) is/are patterned sintered connection layers.

10. The power module (10) according to claim 9,
wherein
- the electrical connection (4) is a metal clip and is electrically connected to the second metallization layer (22) by one connection layer (5) in form of a third connection layer (5D), and
- at least one of the second connection layer (5C) and the third sintered connection layer (5D) is a patterned sintered connection layer.

11. The power module (10) according to claim 10,
wherein the at least one of the second connection layer (5C) and the third sintered connection layer (5D) has a striped layout comprising a plurality of stripes, wherein the stripes are oriented in parallel or perpendicular to the separating trench (2T).

12. The power module (10) according to one of the previous claims comprising at least four module components being a base plate (1), a substrate (2), an electronic component (3) and an electrical connection (4), wherein
- one connection layer (5) in form of a lower sintered connection layer (5A) is formed between the base plate (1) and the substrate (2),
- one connection layer (5) in form of a first connection layer (5B) is formed between the substrate (2) and the electronic component (3),
- one connection layer (5) in form of a second connection layer (5C) is formed between the electronic component (3) and the electrical connection (4), and
- at least one, two or all of the connection layers (5, 5A, 5B, 5C) is/are patterned sintered connection layers.

13. The power module (10) according to one of the previous claims, wherein the at least one connection layer (5) is a silver or copper sintered connection layer.

14. The power module (10) according to one of the previous claims, the not-covered subregions (50U) have a lateral width (W) greater than 0.1 mm.

15. A method for producing a power module (10) according to one of the previous claims, wherein
- for forming the at least one sintered connection layer (5), applying a sinter material on a surface or surfaces of one or of both of the at least two module components (M), and
- during the formation of the at least one sintered connection layer (5), applying predetermined pressure for adjusting the porosity or compactness of the at least one connection layer (5).
